# EUROPEAN PATENT APPLICATION

(11) **EP 2 355 123 A2**
(43) Date of publication of application: **10.08.2011**
(21) Application number: 10177571.6
(22) Date of filing: 20.09.2010
(51) Int. Cl.: H01J 17/16, H05K 5/02

(54) **Electronic apparatus**

(30) Priority: 29.01.2010 JP 2010019708
(71) Applicant: Kabushiki Kaisha Toshiba, Minato-ku Tokyo (JP)
(72) Inventor: Hirano, Masahiro, Tokyo (JP)
(74) Representative: HOFFMANN EITLE

(57) **Abstract**

An electronic apparatus includes: a display device comprising a display screen; a cabinet that houses the display device and is provided with a first opening through which the display screen is exposed and a first hole which is located outside the first opening; a first cover member which is attached to the cabinet and covers the first hole; and a cover portion that is provided inside the cabinet at a position spaced from the first cover member, the cover portion covering at least part of the first hole on the side opposite to the first cover member.

## Description

### CROSS-REFERENCE TO THE RELATED APPLICATION(S)

The present application is based upon and claims priority from prior Japanese Patent Application No. 2010-019708, filed on January 29, 2010, the entire contents of which are incorporated herein by reference.

### FIELD

Embodiments described herein generally relate to an electronic apparatus.

### BACKGROUND

A plasma display apparatus having a configuration suitable for having a large screen size is known. The plasma display apparatus is equipped with a panel having a display screen, a chassis which holds the panel, and a front protective cover which covers the front side of a peripheral portion of the panel. The front protective cover has a front frame having an opening, a protective plate which is made of resin, glass, or the like and attached to the front frame, protective plate pressing metal members for pressing the protective plate from the inside.

In this type of plasma display apparatus, the protective plate is attached to the front frame in such a manner as to be sandwiched between an opening-side portion of the front frame and the protective plate pressing metal members. An example of such configuration is disclosed in JP-A-2007-199705.

In large-screen TV monitors, double-sided adhesive tapes may be used for fixing a protective plate or a decorative plate to a front frame. In this case, if trouble occurs such as dust coming into the space between the front frame and the protective plate or decorative plate or a scratch in the front frame, it is necessary to separate the protective plate or decorative plate from the front frame and do reassembling. A structure is desired that allows such work to be conducted efficiently.

### BRIEF DESCRIPTION OF THE DRAWINGS

A general configuration that implements the various features of the present invention will be described with reference to the drawings. The drawings and the associated descriptions are provided to illustrate embodiments of the invention and not to limit the scope of the invention.
Fig. 1 is a perspective view of a TV receiver according to an embodiment.
Fig. 2 is a vertical sectional view of the TV receiver according to the embodiment.
Fig. 3 is an exploded perspective view of a front unit of the TV receiver according to the embodiment.
Fig. 4 is a front view of a front cover of the TV receiver according to the embodiment.
Fig. 5 is a front view of part of the front cover of the TV receiver according to the embodiment.
Fig. 6 is a rear view of the front cover of the TV receiver according to the embodiment.
Fig. 7 is a rear view of part of the front cover of the TV receiver according to the embodiment.
Fig. 8 shows a process of removing a decorative panel from the front cover according to the embodiment.
Fig. 9 is a rear view of a front cover of a TV receiver according to a modification of the embodiment.
Fig. 10 shows a process of removing a decorative panel from the front cover according to the modification of the embodiment.

### DETAILED DESCRIPTION

According to the embodiments described herein, there is provided an electronic apparatus including: a display device comprising a display screen; a cabinet that houses the display device and is provided with a first opening through which the display screen is exposed and a first hole which is located outside the first opening; a first cover member which is attached to the cabinet and covers the first hole; and a cover portion that is provided inside the cabinet at a position spaced from the first cover member, the cover portion covering at least part of the first hole on the side opposite to the first cover member.

Embodiments according to the present invention will be described in detail with reference to the accompanying drawings. The scope of the claimed invention should not be limited to the examples illustrated in the drawings and those described in below.

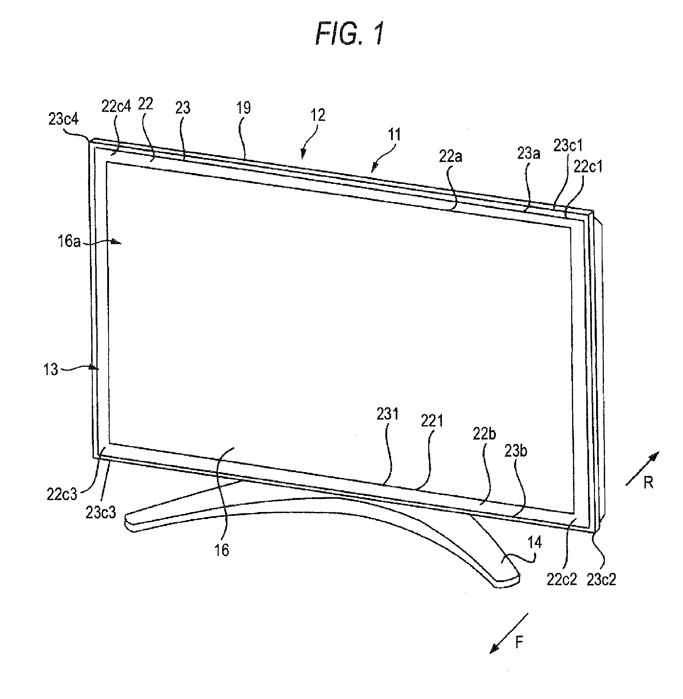

A TV receiver will be hereinafter described with reference to Figs. 1-10 as an example of an electronic apparatus according to an embodiment of the present invention.

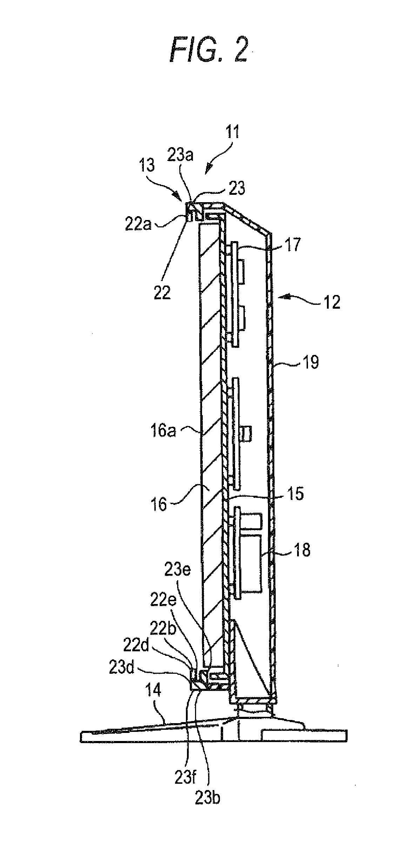

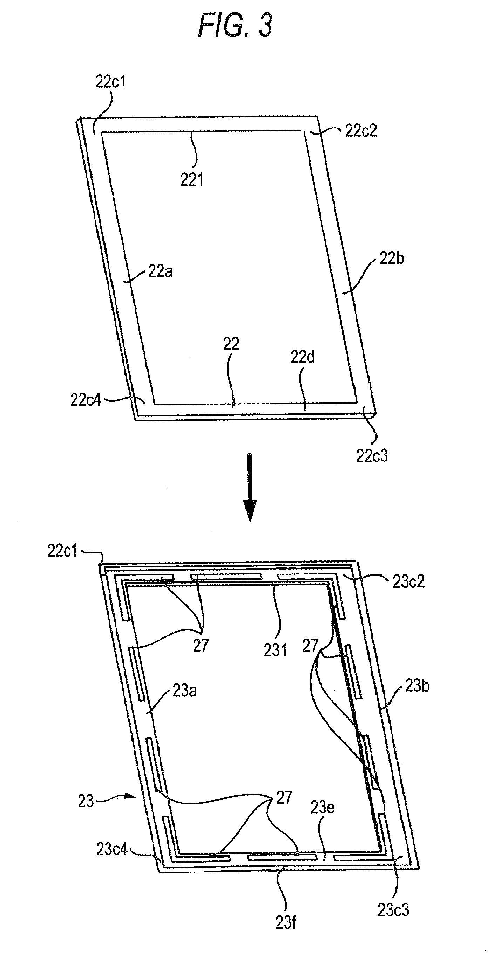

A configuration of the TV receiver according to the embodiment will be described with reference to Figs. 1-3. Fig. 1 is a perspective view of the TV receiver according to the embodiment. Fig. 2 is a vertical sectional view of the TV receiver according to the embodiment. Fig. 3 is an exploded perspective view of a front unit of the TV receiver according to the embodiment.

As shown in Figs. 1 and 2, the TV receiver 11 is equipped with a main body 12 including a liquid crystal panel 16 and the front unit 13 which covers the front side of a peripheral portion of the liquid crystal panel 16. The main body 12 has a stand 14 which serves as a support stand of the main body 12, a rectangular-plate-shaped frame 15 which is located over and supported by the stand 14, the liquid crystal panel 16 which is an example display and has a display screen 16a, a panel controller 17 for driving the liquid crystal panel 16, a power unit 18 for supplying power to the liquid crystal panel 16 etc., and a back cover 19 which covers the main body 12 from the back side. In Fig. 1, arrows F and R indicate the front side and the back side, respectively, of the TV receiver 11.

The front unit 13 and the back cover 19 constitute a cabinet which is an outer covering of the TV receiver 11. For example, the panel controller 17 and the power unit 18 are fixed to the back surface of the frame 15. Although the embodiment employs the liquid crystal panel 16 as an example display, the invention is not limited to such a case. The display may be any of other display panels such as an organic EL device and a plasma display.

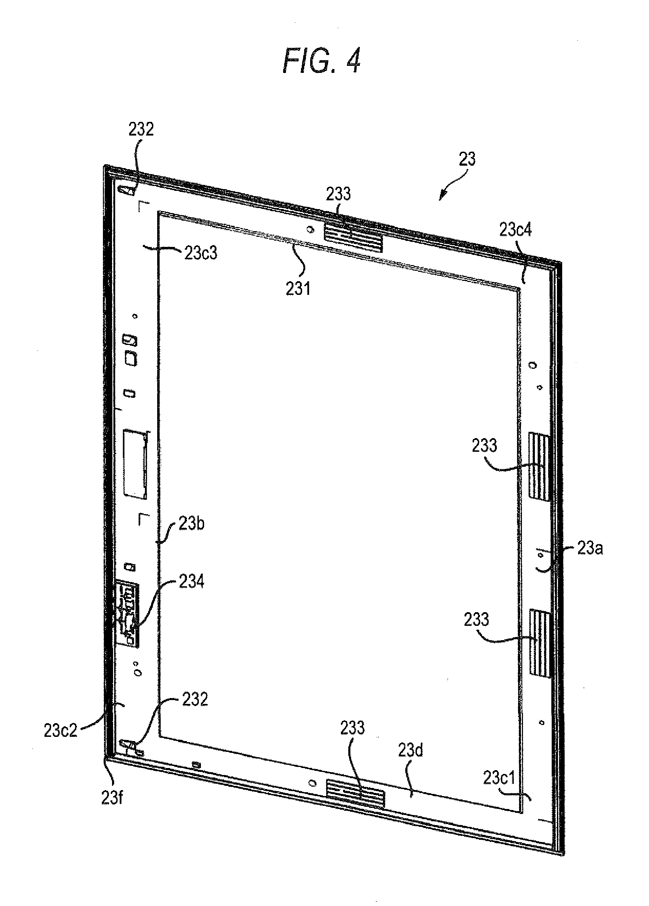

The front unit 13 is fixed to the frame 13 with such means as screws. As shown in Figs. 3 and 4, the front unit 13 has a decorative panel 22, a front cover 23 which supports a peripheral portion of the decorative panel 22, plural through-holes formed through the front cover 23, and plural bonding members 27 which are sandwiched between the decorative panel 22 and the front cover 23. The bonding members 27, which are double-sided adhesive tapes, for example, join the decorative panel 22 and the front cover 23 to each other.

The decorative panel 22 of the embodiment has a top portion 22a, a bottom portion 22b, corner portions 22c1-22c4, a front surface 22d, and a back surface 22e. For example, the decorative panel 22 is formed by shaping acrylic resin into a rectangular, frame-shaped plate. The decorative panel 22 is provided with an opening 221 for exposing the display screen 16a. The front cover 23 has a top portion 23a, a bottom portion 23b, corner portions 23c1-23c4, a front surface 23d, a back surface 23e, and side walls 23f. The front cover 23 is provided with an opening 231 which corresponds to the opening 221 of the decorative panel 22 and serves to expose the display screen 16a.

The decorative panel 22, which is made of an opaque material, a .low-transparency material, or the like, covers at least part of the front surface of the front cover 23 and can thereby improve the front appearance of the TV receiver 11.

As described above, the decorative panel 22 of the embodiment is a plate-like member for adding to the beauty of the front surface of the front cover 23 and is made of such a material as flexible plastics. The decorative panel 22 is lower in the probability of damaging the front cover 23 or the display screen 16a of the liquid crystal panel 16 during work of attaching it than in a case that it is made of a rigid material such as glass or metal. By virtue of its flexibility, the decorative panel 22 of the embodiment can lower the probability that the decorative panel 22 itself or the front cover 23 is damaged in a process of removing it from the front cover 23.

Since the decorative panel 22 and the front cover 23 are prevented from being deformed or damaged when they are separated from each other, they can be reused. Where the decorative panel 22 and the front cover 23 are made of different materials, they can easily be discriminated from each other when they are discarded.

Although the embodiment is directed to the example process of separating the decorative panel 22 from the front cover 23, the invention is not limited to such a case. For example, the invention can also be applied to a protective panel (not shown) for protecting the display area 16a of the liquid crystal panel 16 and its neighboring region, in which case the invention can increase the efficiency of the work of removing the protective panel from the front cover 23.

Next, a structure capable of increasing the efficiency of the work of removing the decorative panel 22 from the front cover 23 according to the embodiment will be described in detail with reference to Fig. 4-8.

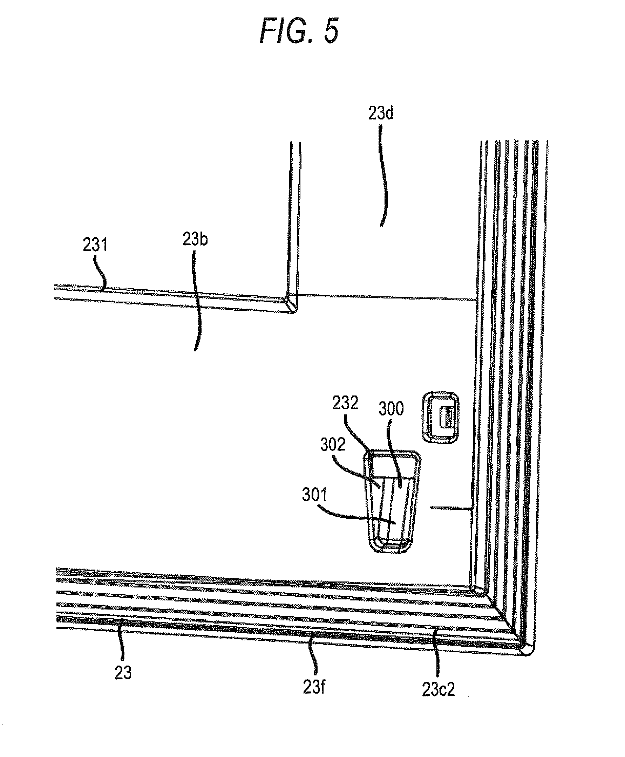

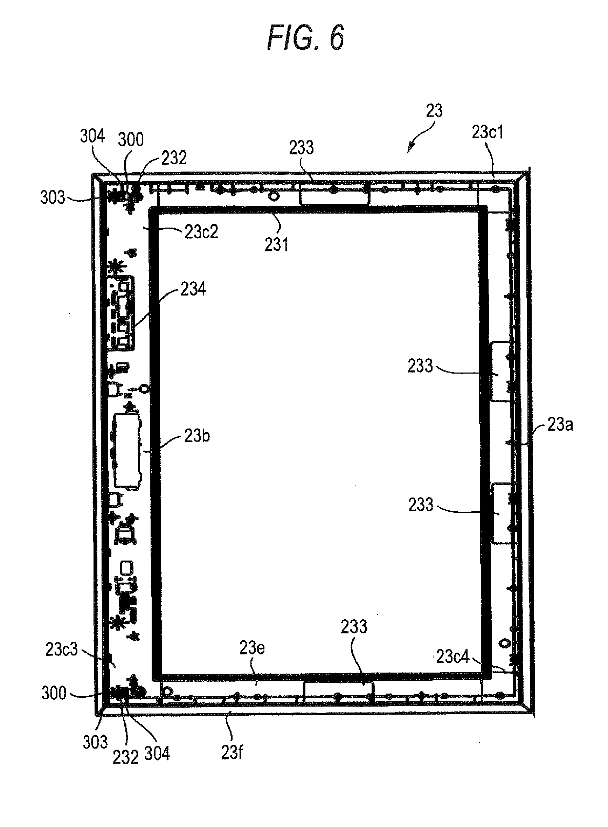

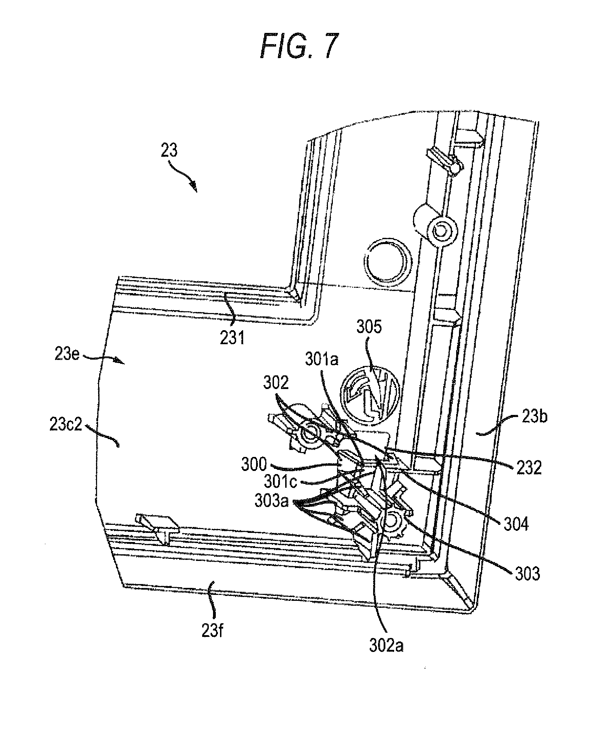

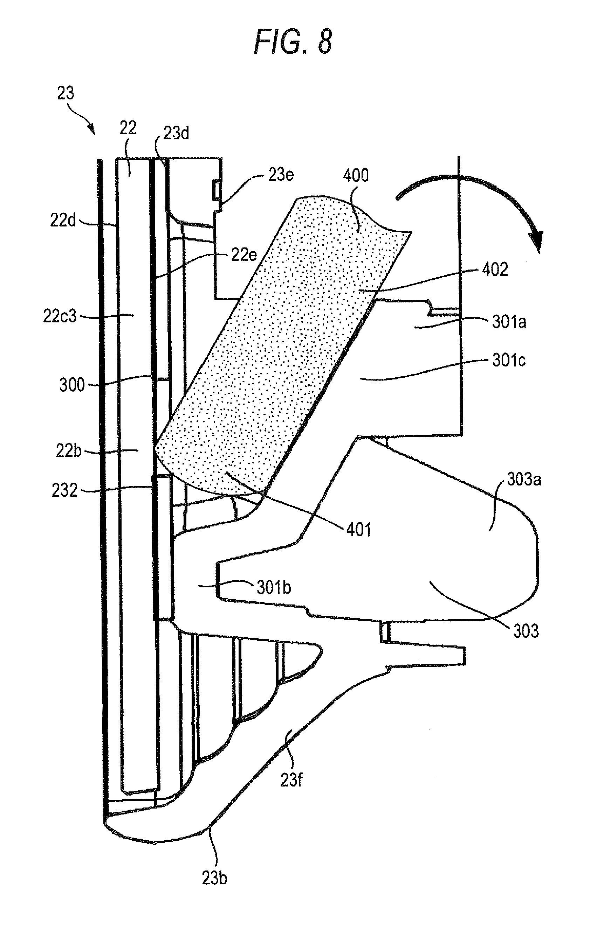

Fig. 4 is a front view of the front cover 23 of the TV receiver 11 according to the embodiment. Fig. 5 is a front view of part of the front cover 23 of the TV receiver 11 according to the embodiment. Fig. 6 is a rear view of the front cover 23 of the TV receiver 11 according to the embodiment. Fig. 7 is a rear view of part of the front cover 23 of the TV receiver 11 according to the embodiment. Fig. 8 shows a process of removing the decorative panel 22 from the front cover 23 according to the embodiment.

As shown in Figs. 4 and 6, in the front cover 23, holes 232 through which a jig can be inserted are formed in the respective corner portions 23c2 and 23c3 which are adjacent to the bottom portion 23b. The jig means a rod-shaped member such as a screwdriver.

In the front cover 23 of the embodiment, holes 233 for enabling expansion and contraction of the decorative panel 22 and a hole 234 in which to mount components such as a circuit board (not shown) are formed around the opening 231. In the embodiment, these holes 232-234 are covered with the decorative panel 22 and hence are not exposed to the outside.

As shown in Figs. 5 and 7, in the front cover 23, a projection 300 which projects toward the inside of the cabinet is formed near each hole 232. The projection 300 has a cover portion 301 which covers at least part of the hole 232 when viewed from inside the cabinet and a pair of side walls 302 which extend from portions adjacent to the hole 232 and bridge the cover portion 301 and the front cover 23. The cover portion 301 has a portion that is opposed to the decorative panel 22 with the hole 232 interposed in between.

As shown in Figs. 5, 7, and 8, the cover portion 301 has an end portion 301a which is spaced from the front cover 23, a continuous portion 301b which is continuous with the front cover 23, and a slant portion 301c which bridges the end portion 301a and the continuous portion 301b. The slant portion 301c extends in a direction that crosses the respective planes in which the front cover 23 and the decorative panel 22 exist. That is, when the TV receiver 11 according to the embodiment is placed on the top plate, for example, of a desk in such a manner that the display screen 16a is approximately perpendicular to the top plate, the slant portion 301c is inclined from the top plate.

As shown in Figs. 7 and 8, the front cover 23 is provided with bosses 303 each of which is fitted with a fixing member (not shown) for joining the front cover 23 to the back cover 19. Each boss 303 is provided with plural boss support portions 303a for supporting the boss 303.

As shown in Fig. 7, each projection 300 of the embodiment is provided near the associated boss 303. More specifically, each projection 300 is provided in such a manner that part of the slant portion 301c enters the boss 303. The slant portion 301c is integral with some boss support portions 303a. One boss support portion 303a extends along a central portion of the slant portion 301c. This structure can increase the rigidity of the projection 300.

As shown in Fig. 7, the back surface 23a of the front cover 23 is provided with ribs 304 which extend parallel with the respective side walls 23f. Each projection 300 of the embodiment is provided near the associated rib 304. More specifically, part of the slant portion 301c enters the rib 304 and the slant portion 301c is integral with the rib 304. The rib 304 extends along the periphery of the end portion 301a. This structure can increase the rigidity of the projection 300.

As shown in Figs. 5, 7, and 8, each cover portion 301 and the front cover 23 form a hole 302a which is located inside the cabinet and has an open top. The hole 302a communicates with the associated hole 232 of the front cover 23. Therefore, in being inserted into the hole 232 from the back side, a jig 400 passes through the hole 302a first and then reaches the hole 232.

When an end portion (not shown), opposite to a tip portion 401, of the jig 400 is pushed downward in a state that the jig 400 is inserted in the hole 232, that is, the tip portion 401 of the jig 400 is in contact with the decorative panel 22 through the hole 232, the jig 400 is rotated with its portion 402 of contact with the end portion 301a serving as the fulcrum and separates the decorative panel 22 from the portion, around the hole 232, of the front cover 23.

Indicators 305 indicating that part of the decorative panel 22 can easily be separated from the front cover 23 utilizing the leverage are provided on the back surface 23e of the front cover 23. This allows an operator to recognize that part of the decorative panel 22 can be separated from the front cover 23 utilizing the leverage. Although in the embodiment the indicators 305 are molded together with the front cover 23, the invention is not limited to such a case. The indicators 305 may be provided by attaching seals, using paint, or a similar manner.

As described above, according to the embodiment, part of the decorative panel 22 can easily be separated from the front cover 23 utilizing the leverage. As described above, the holes 232 of the embodiment are provided in the respective corner portions 23c1 and 23c3 of the front cover 23 which are adjacent to the bottom portion 23b. Therefore, end portions of the decorative panel 22 are peeled off with the jig 400, and hence the decorative panel 22 can easily be separated from the front cover 23 by gripping those end portions.

In the embodiment, each hole 302a has an open top. And the slant portion 301c exists adjacent to each hole 302a and the associated hole 232 of the front cover 23. Therefore, when inserted into the hole 302a from the side of the top portion 23a of the front cover 23, the jig 400 reaches the hole 232 smoothly being guided by the slant portion 301c.

With the above-described structure, in the embodiment, work of inserting the jig 400 which is one step of a process of separating the decorative panel 22 from the front cover 23 can be conducted easily and its efficiency is increased.

In the embodiment, each projection 300 is integral with the associated boss 303 and rib 304. For example, when it is attempted to remove part of the decorative panel 22 from the front panel 23 utilizing the leverage by inserting the jig 400 into one hole 302a, stress is imposed on the projection 300, in particular, its end portion 301a. However, in the embodiment, since the projection 300 is integral with the boss 303 and the rib 304, the resistance to the stress occurring in the peeling work can be increased.

In the embodiment, the projections 300 are integral with the front cover 23. This can make the resistance to the stress occurring in the peeling work higher than in a case that the projections 300 are provided separately from the front cover 23.

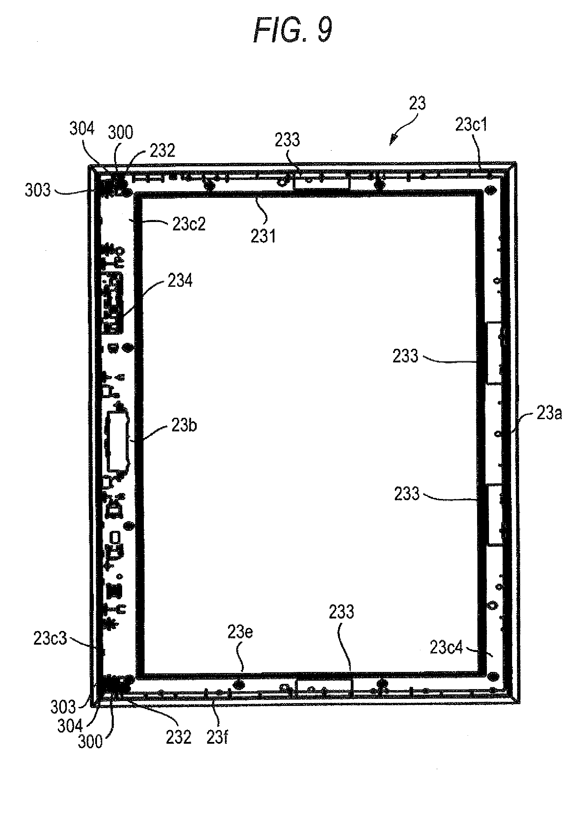

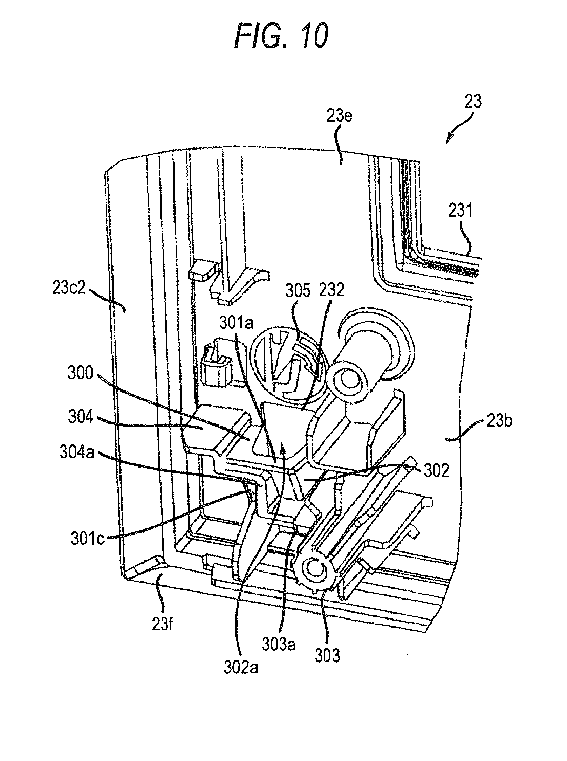

Fig. 9 is a rear view of a front cover of a TV receiver according to a modification of the embodiment. Fig. 10 shows a process of removing a decorative panel from the front cover according to the modification of the embodiment. The TV receiver according to the modification of the embodiment will be described below with reference to Figs. 9 and 10. Members etc. having the same or equivalent (in function) ones in the first embodiment will be given the same reference symbols as the latter and will not be described in detail. The members etc. that will not be described below are the same as in the first embodiment.

As shown in Figs. 9 and 10, in the modification, a boss 303 and projection 300 that are associated with each other are spaced from each other more than in the embodiment. The projection 300 is integral with a rib 304. The rib 304 has a reinforcement portion 304a which extends along a central portion of the slant portion 301c. The reinforcement portion 304a is thicker than the other portions of the rib 204. The reinforcement portion 304a is continuous with one boss support portion 303a. This structure can increase the rigidity of the projection 300 as in the case of the first embodiment.

As described above, according to the embodiment and its modification, the degree of freedom of designing relating to such items as a size change of the TV receiver 11 and a change in the arrangement of mounted components can be increased.

Electronic apparatus to which the invention is applied are not limited to TV receivers and include displays of personal computers, for example. Inventive electronic apparatus can be modified in various manners without departing from the spirit and scope of the invention.

Although the embodiments according to the present invention have been described above, the present invention may not be limited to the above-mentioned embodiments but can be variously modified. Components disclosed in the aforementioned embodiments may be combined suitably to form various modifications. For example, some of all components disclosed in the embodiments may be removed or may be appropriately combined.

Additional advantages and modifications will readily occur to those skilled in the art. Therefore, the invention in its broader aspects may not be limited to the specific details and representative embodiments shown and described herein. Accordingly, various modifications may be made without departing from the spirit or scope of the general inventive concept as defined by the appended claims and their equivalents.

## Claims

1. An electronic apparatus comprising:
a display device comprising a display screen;
a cabinet that houses the display device and is provided with a first opening through which the display screen is exposed and a first hole which is located outside the first opening;
a first cover member which is attached to the cabinet and covers the first hole; and
a cover portion that is provided inside the cabinet at a position spaced from the first cover member, the cover portion covering at least part of the first hole on the side opposite to the first cover member.

2. The apparatus of Claim 1,
wherein the cover portion is formed to project from a portion near the first hole of the cabinet.

3. The apparatus of Claim 2,
wherein the first cover member formed in a frame shape and is formed with a second opening through which the display screen is exposed.

4. The apparatus of Claim 3,
wherein the first hole is located near a corner of the display screen.

5. The apparatus of Claim 4,
wherein the cabinet comprises a support member,
wherein the first cover member comprises a first end portion and a second end portion which is more distant than the first end portion from the support member, and
wherein the first hole is located at a position that is nearer to the second end portion than to the first end portion.

6. The apparatus of Claim 5,
wherein the cover portion comprises a second hole which is open on the side opposite to the support member and through which the first hole communicates with the inside of the cabinet.

7. The apparatus of Claim 6,
wherein at least a part of the cover portion is thicker than a portion that is located in the vicinity of the cover portion.

8. The apparatus of Claim 7,
wherein the cabinet comprises a first member that is provided with the first opening, the first hole, and the cover portion, a second member, and a boss in which a fixing member for fixing the first member and second member to each other is inserted, and
wherein the cover portion is integral with the boss.

9. The apparatus of Claim 7,
wherein the cabinet comprises a second cover member which is formed with the first opening and a rib which surrounds the first opening at least partially, and
wherein the cover portion is integral with the rib.
